# EUROPEAN PATENT APPLICATION

(11) **EP 4 692 946 A1**
(43) Date of publication of application: **11.02.2026**
(21) Application number: 25787316.6
(22) Date of filing: 26.03.2025
(51) Int. Cl.: G03F 7/16, G03F 7/38, B08B 1/14, B05C 11/10

(54) **FULLY-AUTOMATIC PHOTORESIST COATING AND BAKING APPARATUS FOR SCIENTIFIC RESEARCH**

(30) Priority: 11.06.2024 CN 202410743427
(71) Applicant: The Hong Kong University of Science and Technology (Guangzhou), Guangzhou, Guangdong 511400 (CN)
(72) Inventor: XU, Wei, Guangzhou, Guangdong 511400 (CN); WANG, Nina, Guangzhou, Guangdong 511400 (CN); LI, Yijie, Guangzhou, Guangdong 511400 (CN); ZENG, Xiangjun, Guangzhou, Guangdong 511400 (CN); LI, Ji, Guangzhou, Guangdong 511400 (CN)
(74) Representative: Gislon, Gabriele
(86) International application number: PCT/CN2025/084970
(87) International publication number: WO 2025/256222

(57) **Abstract**

The present application discloses a full-automatic spin coating and baking apparatus for scientific research, which relates to the technical field of semiconductor spin coating and baking. The apparatus includes a main body, a first loading device, a second loading device, a manipulator device, a spin coater, a baking device, a pipetting device, a vision device and a control device. The control device is configured to accurately control the manipulator device to grab a small wafer piece from the first loading device based on the positioning recognition of the vision device, and then accurately place the grabbed small wafer piece at a vacuum adsorption hole of the spin coater. After that, the manipulator device is controlled to be linked with the pipetting device, so that the photoresist can be sucked from the second loading device and accurately dripped onto the small wafer piece fixed by adsorption. The spin coater is controlled to perform spin coating treatment on the small wafer piece dripped with photoresist. The manipulator device is controlled to grab the small wafer piece from the spin coater and place it on the baking device after the spin coating treatment is completed. The baking device is controlled to bake. After baking, the manipulator device is controlled to place the small wafer piece back into the first loading device.

## Description

### TECHNICAL FIELD

The present disclosure relates to the technical field of semiconductor coating and baking, and in particular to, a full-automatic spin coating and baking apparatus for scientific research.

### BACKGROUND

A coating and baking apparatus is one of important apparatuses in semiconductor micro-nano processing and manufacturing, which is used together with a lithography machine to coat and bake a photoresist on a wafer surface.

Although there are automatic coating and baking apparatuses in the existing technology, they are all developed for industrial applications and cannot be applied to scientific research scenes. Pieces of wafer with a size of 1 cm × 1 cm or 2 cm × 2 cm (which are obtained by cutting a wafer of 2/4/6/8 inches into several pieces) are often used in scientific research in semiconductor coating and baking in universities and other scientific research sites, due to consideration of flexibility and cost saving of the scientific research.

In existing semiconductor coating and baking scientific research, there are two ways to realize coating and baking of a photoresist on a piece of wafer as follows.
1. Use of independent and separate manual spin coater and hot plate. A specific process flow is as follows: researchers manually pick up and place a piece of wafer on a vacuum adsorption hole of the manual spin coater using a tweezer, manually drip the photoresist on the the piece of wafer using a dropper, and then set parameters of the spin coater to realize coating of the photoresist; then researchers use the tweezer to transfer the piece of wafer to the hot plate for baking, and take the piece of wafer out after the baking. Disadvantages of this method lie in that it is very difficult for a person to pick up and place the piece of wafer in position with the tweezer due to a very small size of the piece of wafer, and the piece of wafer is easy to fragment, resulting in waste of samples. Moreover, it is determined by human eyes whether the piece of wafer is placed on the vacuum adsorption hole of the spin coater when placing the piece of wafer, which cannot ensure that the piece of wafer is placed at the same position every time, resulting in unsatisfactory repeatability of a coating process and low scientific research efficiency. In addition, the researchers are in direct contact with the photoresist, which also poses health hazards.
2. Use of existing full-automatic spin coating and baking apparatus. A specific process flow is as follows: since the existing full-automatic spin coating apparatus is mainly used in semiconductor factories, which can handle a wafer with a minimum size of 2 inches, the researchers need to first stick a piece of wafer on the 2-inch wafer with double-sided tape, then operate the apparatus to realize coating and baking, and then take the piece of wafer off from the 2-inch wafer after the baking. Disadvantages of this method lie in that it cannot ensure that the piece of wafer is attached at the same position on the 2-inch wafer every time, resulting in unsatisfactory repeatability of the coating process and low scientific research efficiency.

To sum up, it can be found that there is no coating and baking apparatus that can be applied to scientific research scenes in the existing technology, resulting in that existing semiconductor coating and baking researches still have technical problems of unsatisfactory process repeatability, low efficiency, easy waste of samples and health hazards. Therefore, there is an urgent need to provide a scheme to alleviate the above problems.

### SUMMARY

In view of the above, an object of the present disclosure is to provide a full-automatic spin coating and baking apparatus for scientific research, so as to solve technical problems of unsatisfactory process repeatability, low efficiency, easy waste of samples and health hazards that still exist in existing semiconductor spin coating and baking researches.

To achieve the above technical object, the present disclosure provides a full-automatic spin coating and baking apparatus for scientific research. The apparatus includes an apparatus body, a first loading device, a second loading device, a manipulator device, a spin coating device, a baking device, a pipetting device, a vision device and a control device;
the first loading device is mounted on the apparatus body for loading a piece of wafer;
the second loading device is mounted above the apparatus body for loading a photoresist;
the spin coating device is mounted on the apparatus body for spin coating the piece of wafer dripped with the photoresist;
the baking device is mounted on the apparatus body for baking the piece of wafer subjected to spin coating;
the manipulator device is mounted on the apparatus body and includes a manipulator body and a manipulator displacement driving mechanism;
the manipulator body is capable of grasping the piece of wafer;
the manipulator device is configured to transport the piece of wafer among the first loading device, the spin coating device and the baking device;
the pipetting device is electrically connected to the manipulator displacement driving mechanism, and is capable of aspirating the photoresist from the second loading device and dripping the photoresist on the piece of wafer under driving of the manipulator device;
the vision device is electrically connected to the manipulator displacement driving mechanism for identifying a position of a target object and transmitting the position to the control device; and
the control device is electrically connected to the manipulator device, the spin coating device, the baking device, the pipetting device and the vision device.

In an embodiment, the first loading device includes a first loading body structure;
each of several first loading grooves for holding a respective piece of wafer of several piece of wafer of a first preset specification is defined at a top of the first loading body structure;
each of the several first loading grooves is provided with a respective second loading groove of several second loading grooves at a center thereof, each of which is configured for holding a respective one of several pieces of wafer of a second preset specification;
each of the several second loading grooves is movably provided with a respective one of several ejector columns in a penetrating way along a vertical direction at a central position thereof; and the several ejector columns are each electrically connected to a respective ejector driver or are electrically connected to a same ejector driver, so as to eject the respective piece of wafer located on the respective first loading groove or the respective second loading groove by a preset height.

In an embodiment, the first loading body structure includes a box body and a box cover detachably covered on the box body;
each of the several first loading grooves and each of the several second loading grooves are arranged at a top of the box cover;
the full-automatic spin coating and baking apparatus for scientific research further includes a pretreatment device and a forking tool, where:
   the pretreatment device is mounted on the apparatus body;
   the forking tool is placed on the apparatus body;
   the manipulator body is further capable of grasping the forking tool;
   the box cover is provided with a socket for inserting the forking tool;
   the manipulator device is further configured to grasp the forking tool and transport the box cover between the first loading device and the pretreatment device through the forking tool; and the pretreatment device is configured to pretreat each of the several pieces of wafer on the transported box cover.

In an embodiment, the first loading device is provided in two.

In an embodiment, the second loading device includes a second loading body structure; and the second loading body structure is provided with several container fixing grooves each for fixing a respective one of several container bottles storing the photoresist.

In an embodiment, each of the several container bottles is provided with a respective one of several caps which is allowed to be screwed on and screwed off; and
the manipulator body is further configured to be capable of screwing any one of the several caps to open or close a respective one of the several container bottles.

In an embodiment, the second loading device further includes a bottle fixing mechanism;
the manipulator device is further configured to transport a certain container bottle of the several container bottles between the second loading body structure and the bottle fixing mechanism;
the bottle fixing mechanism is configured to clamp and fix the transported container bottle; and
the pipetting device is capable of aspirating the photoresist from the container bottle clamped and fixed on the bottle fixing mechanism.

In an embodiment, each of the several container bottles is provided with the respective one of the several caps which is allowed to be unscrewed;
further including a bottle opening device; and
the bottle opening device is mounted on the apparatus body and is capable of turning any one of the several caps to open or close its respective container bottle.

In an embodiment, the second loading device further includes a bottle fixing mechanism;
the bottle opening device includes a bottle opening displacement driving mechanism and a bottle opening mechanism;
the bottle opening mechanism is capable of grasping any one of the several container bottles;
the bottle opening displacement driving mechanism is electrically connected to the bottle opening mechanism for driving the bottle opening mechanism to transport any one of the several container bottles between the second loading body structure and the bottle fixing mechanism;
the bottle fixing mechanism is configured to clamp and fix the transported container bottle;
the bottle opening mechanism is also capable of screwing its respective cap to open or close the transported container bottle; and
the pipetting device is capable of aspirating the photoresist from the container bottle clamped and fixed on the bottle fixing mechanism.

In an embodiment, the full-automatic spin coating and baking apparatus for scientific research further includes a dispensing device, a stock solution tank and a dispensing holder;
the stock solution tank is mounted on the apparatus body and provided with a cap that is allowed to be turned;
the bottle opening mechanism is also capable of screwing the cap to open or close the stock solution tank;
the dispensing device is electrically connected to the bottle opening displacement driving mechanism and is capable of aspirating the photoresist from the stock solution tank and dripping the photoresist into a container bottle of the several container bottles in the bottle fixing mechanism under driving of the bottle opening displacement driving mechanism; and
the dispensing holder is mounted on the apparatus body for loading the container bottle subjected to dispensing.

In an embodiment, the spin coating device includes a spin coater body and an opening-and-closing cover mechanism for spin coater body;
the apparatus body is provided with a mounting cavity for mounting the spin coater body; and the opening-and-closing cover mechanism for spin coater body is mounted at a top of the mounting cavity for mounting the spin coater body for controlling opening and closing of the spin coater mounting cavity.

In an embodiment, the baking device includes a baking machine body and an opening-and-closing cover mechanism for baking machine body; where
the apparatus body is provided with a mounting cavity for mounting the baking machine body; and
the opening-and-closing cover mechanism for baking machine body is mounted at a top of the mounting cavity for mounting the baking machine body for controlling opening and closing of the mounting cavity for mounting the baking machine body.

In an embodiment, the pipetting device is a pipette.

In an embodiment, a cleaning device is included: where
the cleaning device is configured to provide dust-free paper; and
the manipulator device is further configured to be able to grasp the dust-free paper and perform a preset cleaning and wiping action.

In an embodiment, the cleaning device includes a discharging mechanism, a pulling mechanism and a cutting mechanism, where:
the discharging mechanism includes a drum and a drum driving motor electrically connected to the drum;
the drum is configured to wind the dust-free paper;
the pulling mechanism is configured to pull out and release the dust-free paper on the drum; and
the cutting mechanism is arranged at a side of a discharging end of the pulling mechanism for cutting the released dust-free paper.

In an embodiment, the pulling mechanism includes a roller driving motor and two discharging rollers; where
the two discharging rollers are rotatably arranged up and down respectively, and a conveying gap for pulling and conveying the dust-free paper is formed between the two discharging rollers; and
the roller driving motor is electrically connected to at least one of the two discharging rollers for driving the connected discharging roller to rotate.

In an embodiment, the cleaning device further includes an alcohol sprayer; where
the alcohol sprayer is configured to spray alcohol on the dust-free paper which is conveyed to pass the alcohol sprayer;

In an embodiment, a guide roller set is included; where
the alcohol sprayer includes a spraying pump and a support platform;
the support platform is configured to support the dust-free paper conveyed to pass the support platform;
a spraying cavity is provided within the support platform, and a spraying hole fluidly communicated with the spraying cavity is formed at a top surface of the support platform;
the spraying pump is communicated with the spraying cavity;
the guide roller set is mounted between the support platform and the cutting mechanism, such that the dust-free paper conveyed to pass the support platform is attached to the support platform; and
the manipulator device is further configured to grasp a spin-coated piece of wafer of the several pieces of wafer and bring a back surface of the spin-coated piece of wafer to contact with the dust-free paper on the support platform.

In an embodiment, a paper pressing mechanism is included, and
the paper pressing mechanism is arranged at a side of the support platform for tightly pressing the dust-free paper on the support platform against the support platform.

In an embodiment, the full-automatic spin coating and baking apparatus for scientific research further includes a paper winding mechanism, and
the paper winding mechanism is arranged at a side of the cutting mechanism away from the pulling mechanism for winding the released dust-free paper.

In an embodiment, the apparatus body includes a machine station and a protective cover, where the protective cover is covered on a top of the machine station; and
the first loading device and the second loading device are mounted at a top of the machine station and are located within the protective cover;
a mounting cavity for mounting the spin coating device is provided at the top of the machine station within the protective cover;
a mounting cavity for mounting the baking device is provided at the top of the machine station within the protective cover;
the manipulator device is mounted at the top of the machine station within the protective cover; and
the control device is mounted within the machine station.

As can be seen from the above technical scheme, according to the full-automatic spin coating and baking apparatus for scientific research provided in the present disclosure, the control device can accurately control the manipulator device to grasp the piece of wafer from the first loading device based on location and identification of the vision device and accurately place the grasped piece of wafer at a position of the vacuum adsorption hole of the spin coating device; control the manipulator device to cooperate with the pipetting device to aspirate the photoresist from the second loading device and accurately drip the photoresist on the piece of wafer fixed by adsorption; control the spin coating device to perform spin coating on the piece of wafer dripped with the photoresist; control the manipulator device to grasp the piece of wafer from the spin coating device and place the piece of wafer on the baking device after the spin coating is completed; control the baking device to bake; and after baking, control the manipulator device to grasp the piece of wafer from the baking device and place the piece of wafer back into the first loading device. The full-automatic spin coating and baking apparatus for scientific research provided in the present disclosure can realize full-automatic scientific research operations in semiconductor coating and baking, and the piece of wafer can be accurately grasped and placed in position, which not only reduces waste of samples, but also ensures satisfactory process repeatability, reduces labor intensity of scientific researchers, greatly improves scientific research efficiency and process stability, and effectively contributes to development in semiconductor field and promotion of scientific research work. In addition, contact between the scientific researchers and the photoresist is avoided, a health hazard caused by contact with the photoresist is efficiently addressed, and safety of the scientific researchers is ensured.

### BRIEF DESCRIPTION OF DRAWINGS

In order to describe the embodiments of the present disclosure or the technical scheme in the existing technology clearly, the drawings required in the description of the embodiments or the existing technology will be briefly introduced below. Obviously, the drawings in the following description are only some embodiments of the present disclosure, and other drawings can be obtained according to these drawings by those having ordinary skills in the art without creative effort.
FIG. 1 is a perspective view of a full-automatic spin coating and baking apparatus for scientific research provided in the present disclosure;
FIG. 2 is a perspective view of a full-automatic spin coating and baking apparatus for scientific research provided in the present disclosure, with a protective cover removed;
FIG. 3 is a schematic structural view of cooperation between a manipulator device and a pipetting device of a full-automatic spin coating and baking apparatus for scientific research provided in the present disclosure;
FIG. 4 is a perspective view of a first loading device with several pieces of wafer of a full-automatic spin coating and baking apparatus for scientific research provided in the present disclosure;
FIG. 5 is a perspective view of a second loading device of a full-automatic spin coating and baking apparatus for scientific research provided in the present disclosure;
FIG. 6 is a first partial schematic structural view of a full-automatic spin coating and baking apparatus for scientific research provided in the present disclosure;
FIG. 7 is a partially enlarged schematic view of a full-automatic spin coating and baking apparatus for scientific research provided in the present disclosure;
FIG. 8 is a second partial schematic structural view of a full-automatic spin coating and baking apparatus for scientific research provided in the present disclosure;
FIG. 9 is a partial schematic structural view of a baking device of a full-automatic spin coating and baking apparatus for scientific research provided in the present disclosure;
FIG. 10 is a perspective view of a cleaning device of a full-automatic spin coating and baking apparatus for scientific research provided in the present disclosure; and
FIG. 11 is a partial schematic structural view of a cleaning device of a full-automatic spin coating and baking apparatus for scientific research provided in the present disclosure.

In the drawing: 100. Apparatus Body; 101. Machine Station; 102. Protective Cover; 103. Operation Panel; 104. Buzzer Alarm Light; 105. Second Waste Recycling Port; 106. First Waste Recycling Port; 107. Pretreatment Device; 108. Forking Tool; 109. Tip Box;
200. First Loading Device; 201. Box Body; 202. Box Cover; 203. First Loading Body Structure; 204. Ejector Column; 205. First Loading Groove; 206. Second Loading Groove; 207. Piece of wafer;
300. Second Loading Device; 301. Second Loading Body Structure; 302. Container Fixing Groove; 303. Container Bottle; 304. Bottle Cap; 305. Bottle Fixing mechanism;
400. Manipulator Device; 401. Manipulator Displacement Driving mechanism; 402. Manipulator Body;
501. Liquid Transfer Device; 502. Vision Device;
600. Baking Device; 601. Baking Machine Body; 602. Opening-and-closing Cover Mechanism for Baking Machine Body; 603. Pin;
700. Spin Coating Device; 701. Spin Coater Body; 702. Opening-and-closing Cover Mechanism for Spin Coater Body;
801. Bottle Opening Device; 802. Bottle Opening Displacement Driving mechanism; 803. Bottle Opening Mechanism; 804. Dispensing mechanism; 805. Dispensing Holder; 806. Stock Solution Tank; 807. Tank Cap;
900. Cleaning Device; 901. Drum; 902. Dust-free Paper; 903. Discharging Roller; 904. Pulling Mechanism; 905. Cutting Mechanism; 906. Guide Roller; 907. Drum Driving Motor; 908. Discharging Mechanism; 909. Roller Driving Motor; 910. Paper Winding Mechanism; 911. Support Platform; 912. Paper Pressing Mechanism; 913. Spraying Hole.

### DETAILED DESCRIPTION

Embodiments of the present disclosure will be clearly and thoroughly described in detail hereinafter in conjunction with accompanying drawings. The embodiments described are only part of the embodiments, but not all the embodiments of the present disclosure. All other embodiments obtained by those having ordinary skills in the art without creative effort shall fall within the scope of protection of the embodiments of the present disclosure.

In the description of the present disclosure, it should be understood that orientation or positional relationships indicated by the terms such as "center", "up", "down", "left", "right", "vertical", "horizontal", "inner", "outer" and the like are based on orientation or positional relationships shown in the accompanying drawings, and are used only for ease and brevity of illustration and description, rather than indicating or implying that the mentioned device or component need to have a particular orientation or need to be constructed and operated in a particular orientation. Therefore, such terms should not be construed as limiting of the present disclosure. In addition, the terms such as "first", "second", "third" and the like used herein are merely used for distinguishing technical features, and are not intended to indicate or imply relative importance.

In the description of the present disclosure, unless specified or limited otherwise, the terms "mounted", "connected", "coupled" and the like shall be understood broadly, and can be, for example, fixed connections, detachable connections, or integral connections; it can also be mechanical connections, or electric connections; it can also be direct connections, or indirect connections via intervening structures; it can also be inner communications or interaction of two elements. The specific meaning of the above terms within the present disclosure can be understood by those having ordinary skills in the art according to particular circumstances.

Embodiments of the present disclosure provide a full-automatic spin coating and baking apparatus for scientific research.

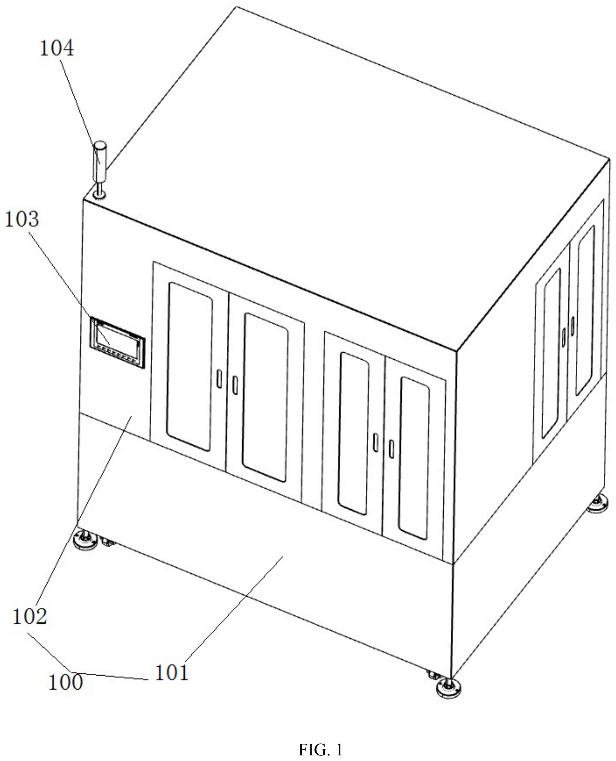

Referring to FIGS. 1 to 4, a full-automatic spin coating and baking apparatus for scientific research provided in an embodiment of the present disclosure includes:
an apparatus body 100, a first loading device 200, a second loading device 300, a manipulator device 400, a spin coating device 700, a baking device 600, a pipetting device 501, a vision device 502 and a control device.

The first loading device 200 is mounted on the apparatus body 100 for loading a piece of wafer 207, that is, a square piece of wafer with a specification of 1 cm × 1 cm or 2 cm × 2 cm. The second loading device 300 is mounted on the apparatus body 100 for loading a photoresist.

The spin coating device 700 is mounted on the apparatus body 100 for spin coating a piece of wafer 207 dripped with the photoresist. The baking device 600 is mounted on the apparatus body 100 for baking the piece of wafer 207 subjected to spin coating.

The manipulator device 400 is mounted on the apparatus body 100 and includes a manipulator body 402 and a manipulator displacement driving mechanism 401.

The manipulator body 402 can be an electric clamp to realize the grasping of the piece of wafer 207.

The manipulator displacement driving mechanism 401 is electrically connected to the manipulator body 402 for driving the manipulator body 402 to transport the piece of wafer 207 among the first loading device 200, the spin coating device 700 and the baking device 600. The manipulator displacement driving mechanism 401 can be a multi-axis robotic arm, such as a six-axis robotic arm, to drive the manipulator body 402 to complete operations such as grasping and placing of the piece of wafer 207.

The pipetting device 501 is electrically connected to the manipulator displacement driving mechanism 401, and is capable of aspirating photoresist liquid from the second loading device 300 and dripping the photoresist liquid on the piece of wafer 207 under driving of the manipulator device 400. The pipetting device 501 is arranged at a side of the manipulator body 402 and is driven together with the manipulator body 402 by the manipulator displacement driving mechanism 401. The pipetting device 501 can realize dripping of the photoresist liquid onto several pieces of wafer 207 at one time by aspirating a certain amount of photoresist for dripping, thus effectively improving efficiency.

The vision device 502 is electrically connected to the manipulator displacement driving mechanism 401 for identifying a target object and transmitting the position to the control device. The vision device 502, which is an image acquisition device such as a Charge Coupled Device (CCD) camera, serves to identify positions of the piece of wafer 207, an adsorption station on the spin coating device 700, a baking station on the baking device 600 or the like, so as to ensure that the manipulator displacement driving mechanism 401 can accurately move the manipulator to a corresponding position and achieve accurate positioning. Manipulator equipped with the vision device 502 adopts a design that already exists, such as cooperative manipulator design or the like, which will not be described in detail.

The control device is electrically connected to the manipulator device 400, the spin coating device 700, the baking device 600, the pipetting device 501 and the vision device 502, and acts as a control center for controlling.

The control device can accurately control the manipulator device 400 to grasp the piece of wafer 207 from the first loading device 200 based on location and identification of the vision device 502 and accurately place the grasped piece of wafer 207 at a position of the vacuum adsorption hole of the spin coating device 700; control the manipulator device 400 to cooperate with the pipetting device 501 to aspirate the photoresist from the second loading device 300 and accurately drip the photoresist on the piece of wafer 207 fixed by adsorption; control the spin coating device 700 to perform spin coating on the piece of wafer 207 dripped with the photoresist; control the manipulator device 400 to grasp the piece of wafer 207 from the spin coating device 700 and place the piece of wafer 207 on the baking device 600 after the spin coating is completed; control the baking device 600 to bake; and after baking, control the manipulator device 400 to grasp the piece of wafer 207 from the baking device 600 and place the piece of wafer 207 back into the first loading device 200. The full-automatic spin coating and baking apparatus for scientific research provided in the present disclosure can realize full-automatic spin scientific research operations in semiconductor coating and baking, and the piece of wafer 207 can be accurately picked up and placed, which not only reduces waste of samples, but also ensures satisfactory process repeatability, reduces labor intensity of scientific researchers, greatly improves scientific research efficiency and process stability, and effectively contributes to development in semiconductor field and promotion of scientific research work. In addition, contact between the scientific researchers and the photoresist is avoided, a health hazard caused by contact with the photoresist is efficiently addressed, and safety of the scientific researchers is ensured.

The above is Example Embodiment one of the full-automatic spin coating and baking apparatus for scientific research provided in the embodiments of the present disclosure. Example Embodiment two of the full-automatic spin coating and baking apparatus for scientific research provided in the embodiments of the present disclosure is described below, and reference can be made to FIGS. 1 to 11.

### Example Embodiment two on a basis of a scheme of Example Embodiment one

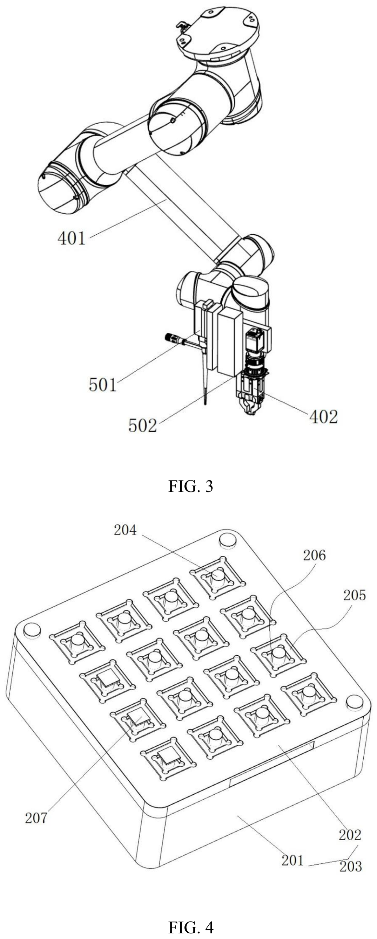

As shown in FIGS. 3 and 4, the first loading device 200 includes a first loading body structure 203.

Several first loading grooves 205 for holding a piece of wafer 207 of a first preset specification are provided at a top of the first loading body structure 203, and the first preset specification can be 2 cm × 2 cm.

A center of each of the several first loading grooves 205 is provided with a respective one of several second loading grooves 206 for holding pieces of wafer 207 of a second preset specification, which can be 1 cm × 1 cm. Such a nested double-groove design can realize compatibility of two types of pieces of wafer 207 in one station area, to achieve a more compact overall structure. Of course, the number of grooves can be increased according to needs, or can be varied and designed by those having ordinary skills in the art according to actual needs, which is not limited herein.

Several ejector columns 204 movably penetrating through the several second loading grooves 206 are provided at a central position of the second loading grooves 206 along a vertical direction, and the ejector columns 204 are each electrically connected to a respective ejector driver (not shown) or are electrically connected to the same ejector driver, so as to eject a piece of wafer 207 located on the first loading groove 205 or the second loading groove 206 by a preset height. The ejector driver(s) can be a vertical displacement driving module such as an electric push rod and a telescopic cylinder, as long as it can drive the ejector column 204 to eject, which is not limited.

The control device is electrically connected to the ejector driver(s) to realize automatic control of ejector driving. The scientific researcher loads the piece of wafer 207 into a corresponding loading groove. When the manipulator device 400 picks up the piece of wafer, the ejector driver first drives the piece of wafer 207 that needs to be picked up to rise by a certain height, thus ensuring that the manipulator body 402 can grasp the piece of wafer 207 without being interfered with, thereby improving grasping efficiency.

The first loading body structure 203 includes a box body 201 and a box cover 202 detachably covered on the box body 201. The first loading groove 205 and the second loading groove 206 are arranged on the box cover 202, and a sufficient mounting space can be formed between the box body 201 and the box cover 202 for mounting the ejector column 204 and the ejector driver.

With the separation design of the box cover 202 and the box body 201, the full-automatic spin coating and baking apparatus for scientific research provided in the present disclosure is further provided with a pretreatment device 107 and a forking tool 108.

The pretreatment device 107 is mounted on the apparatus body 100. The pretreatment device 107 can be an HMDS (hexamethyldisilazane) pretreatment device, which can be varied and designed according to actual needs and will not be described in detail.

The forking tool 108 is arranged on the apparatus body 100, which can be a Y-shaped tool or a forklift tooth-like structure or the like.

The manipulator body 402 can also grasp the forking tool 108. The box cover 202 is provided with a socket for inserting the forking tool 108.

The manipulator device 400 is further configured to grasp the forking tool 108 and transport the box cover 202 between the first loading device 200 and the pretreatment device 107 through the forking tool 108, where the pretreatment device 107 is configured to pretreat the piece of wafer 207 on the transported box cover 202.

A pretreatment process is as follows.

The control device controls the manipulator device 400 to grasp the forking tool 108 to fork the box cover 202 with the piece of wafer 207 and transport the box cover 202 to the pretreatment device 107, controls the pretreatment device 107 to pretreat the piece of wafer 207 on the box cover 202, and controls the manipulator device 400 to transport the processed piece of wafer 207 back to the first loading device 200 and put the forking tool 108 back to its original position.

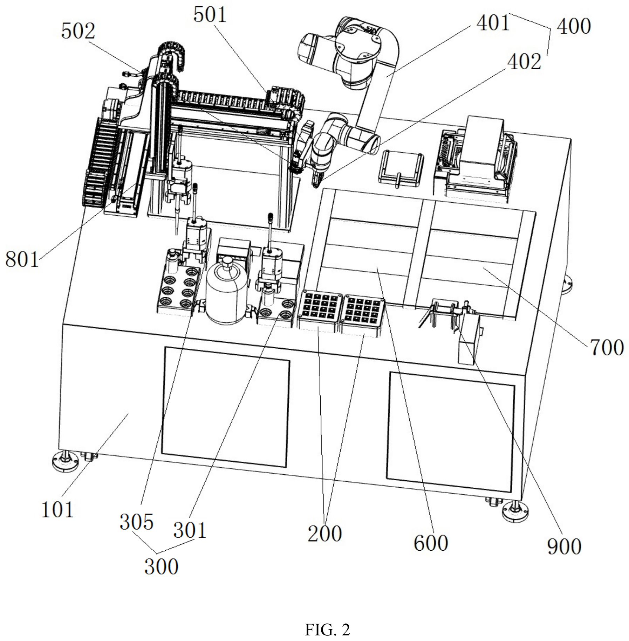

As shown in FIG. 2, there are preferably two first loading devices 200. One of the two first loading devices 200 is configured to hold a piece of wafer 207 to be processed, and the other one of the two first loading devices 200 is configured to hold the processed piece of wafer 207.

Taking the full-automatic spin coating and baking apparatus for scientific research according to an embodiment of the present disclosure being configured with the pretreatment device 107 as an example, one of the two first loading devices 200 can be configured to hold the piece of wafer 207 in the pretreatment process and a spin coating process, that is, the piece of wafer 207 placed on this first loading device 200 are subjected to both pretreatment and spin coating operations. The other one of the two first loading devices 200 can be configured to hold a piece of wafer 207 in the spin coating process, that is, the piece of wafer 207 placed on this first loading device 200 is only subjected to the spin coating treatment, so as to realize differentiated placement.

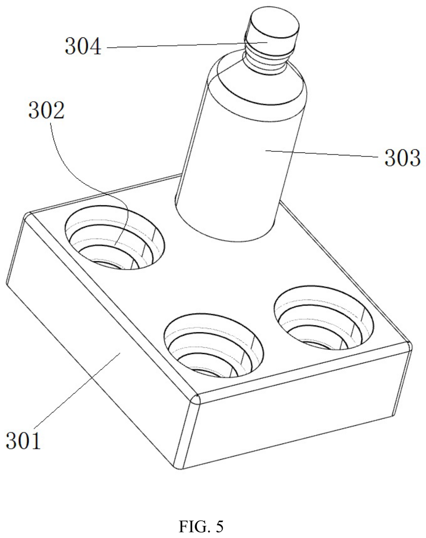

As shown in FIG. 5, for design of the second loading device 300, the second loading device 300 includes a second loading body structure 301, which can be of a seat plate structure.

The second loading body structure 301 is provided with several container fixing grooves 302 for fixing container bottles 303 storing the photoresist. The container fixing groove 302 can be of a stepped groove design, which can realize fixing of container bottles 303 with different diameters and thus has better applicability.

As shown in FIG. 5, taking a design in which the container bottle 303 is provided with a cap 304 which can be unscrewed as an example, the manipulator body 402 can be further configured to be capable of screwing the cap 304 to open or close the container bottle 303. In an embodiment, the manipulator body 402 is further configured with a rotary module. After the manipulator body 402 grasps the cap 304, the manipulator body can turn the cap 304 under an action of the rotary module to unscrew or tighten the cap 304.

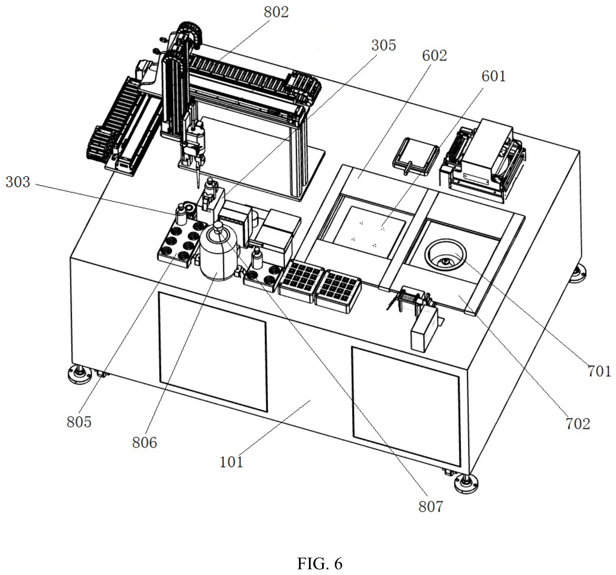

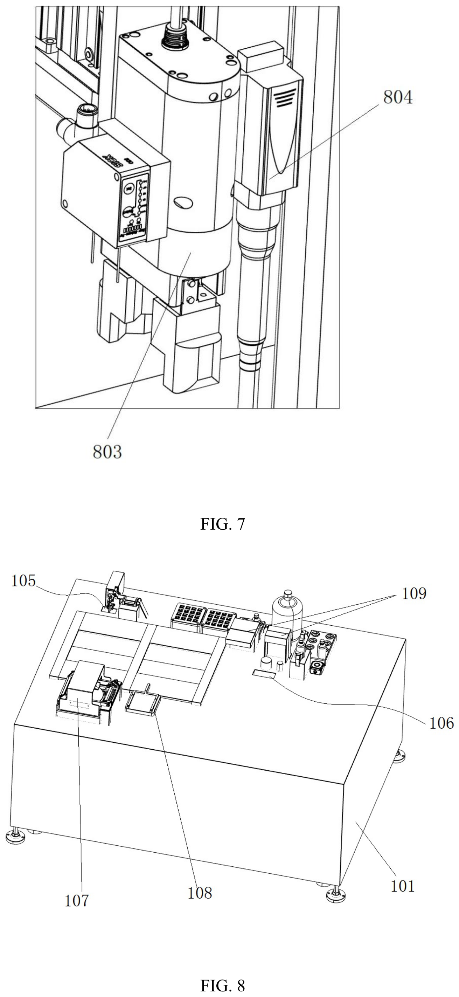

As shown in FIGS. 6 and 7, in order to ensure that the container bottle 303 will not move when screwing the cap 304, the second loading device 300 is further configured to include a bottle fixing mechanism 305.

The manipulator device 400 is further configured (the manipulator displacement driving mechanism 401 is further configured to drive the manipulator body 402) to transport the container bottle 303 between the second loading body structure 301 and the bottle fixing mechanism 305, and the bottle fixing mechanism 305 is configured to clamp the transported container bottle 303.

The control device is electrically connected to the bottle fixing mechanism 305. When the cap 304 needs to be screwed off or screwed on, the control device controls the manipulator device 400 to grasp the container bottle 303 and put the container bottle on the bottle fixing mechanism 305, drives the bottle fixing mechanism 305 to realize clamping and fixing of the container bottle 303, and then controls the manipulator device 400 to complete the screwing on or screwing off of the cap 304. The bottle fixing mechanism 305 can be a conventional clamping and fixing device, which can fix the container bottle 303 in a clamping manner.

The pipetting device 501 can aspirate the photoresist from the container bottle 303 clamped and fixed on the bottle fixing mechanism 305.

Taking the container bottle 303 configured with the cap 304 as an example, as shown in FIGS. 1 and 5, in addition to designing the manipulator device 400 to be capable of screwing off the cap 304, an independent bottle opening device 801 can be additionally provided.

The bottle opening device 801 is mounted on the apparatus body 100, and can turn the cap 304 to open or close the container bottle 303.

As shown in FIGS. 6 and 7, taking the full-automatic spin coating and baking apparatus for scientific research according to an embodiment of the present disclosure being provided with the bottle fixing mechanism 305 as an example, the bottle opening device 801 can be configured to include a bottle opening displacement driving mechanism 802 and a bottle opening mechanism 803. The control device is electrically connected to the bottle opening device 801, and the second loading device 300 is still configured to include the bottle fixing mechanism 305.

The bottle opening mechanism 803 can grasp the container bottle 303. The bottle opening displacement driving mechanism 802 is electrically connected to the bottle opening mechanism 803 for driving the bottle opening mechanism 803 to transport the container bottle 303 between the second loading body structure 301 and the bottle fixing mechanism 305. The bottle fixing mechanism 305 is configured to clamp and fix the transported container bottle 303. The bottle opening mechanism 803 is also capable of screwing the cap 304 to open or close the container bottle 303. The pipetting device 501 is capable of aspirating the photoresist from the container bottle 303 clamped and fixed on the bottle fixing mechanism 305.

In an embodiment, the control device controls the bottle opening device 801 to grasp the container bottle 303 and place the container bottle in the bottle fixing mechanism 305, controls the bottle fixing mechanism 305 to clamp and fix the container bottle 303, controls the bottle opening device 801 to unscrew the cap 304, controls the manipulator to move onto the container bottle 303 and enable a tip of the pipetting device 501 to extend into the container bottle 303, and then controls the pipetting device 501 to aspirate the photoresist.

The additional providing of an independent bottle opening device 801 to realize bottle opening allows the bottle opening and a process performed by the manipulator device 400 to be synchronized to further improve efficiency.

The bottle opening mechanism 803 can be an electric jaw, which is electrically connected to a rotary module. When the cap 304 is grasped, the rotary module can drive the electric jaw to complete screwing of the cap 304. The bottle opening displacement driving mechanism 802 can be a three-axis displacement module composed of, for example, an X-axis linear sliding table, a Y-axis linear sliding table, and a Z-axis linear sliding table, which is not particularly limited herein.

As shown in FIGS. 6 and 7, the full-automatic spin coating and baking apparatus for scientific research further includes a dispensing device 804, a stock solution tank 806 and a dispensing holder 805.

The stock solution tank 806 is mounted on the apparatus body 100 and is provided with a cap 807 which can be screwed. The stock solution tank 806 can store a larger volume of photoresist as compared with the container bottle 303. Therefore, when a certain volume of photoresist is needed, a certain volume of liquid can be taken from the stock solution tank 806.

The bottle opening mechanism 803 mentioned above is configured to be capable of screwing the cap 807 to open or close the stock solution tank 806, and a body of the stock solution tank 806 is fixed with a corresponding fixing mechanism to avoid affecting opening or closing of the cap 807.

The dispensing device 804 is electrically connected to the bottle opening displacement driving mechanism 802, and can aspirate the photoresist from the stock solution tank 806 and drip the photoresist into the container bottle 303 in the bottle fixing mechanism 305 under driving of the bottle opening displacement driving mechanism 802. The dispensing device 804 has the same function as the pipetting device 501, and can be the same liquid transferring module, which is not particularly limited herein.

The dispensing holder 805 is mounted on the apparatus body 100 for loading the container bottle 303 subjected to dispensing. When in use, the container bottle 303 can be transferred to the second loading body structure 301.

Quantitative dispensing for the container bottle 303 can be realized by providing the dispensing device 804, such that a required amount of photoresist can be accurately and quantitatively aspirated every time the photoresist in the container bottle 303 is all aspirated to avoid excessive or less aspiration.

As shown in FIGS. 6 and 7, the spin coating device 700 according to an embodiment of the present disclosure is configured to include a spin coater body 701 and an opening-and-closing cover mechanism for spin coater body 702. The spin coater body 701 can be an existing manual spin coater, which is not particularly limited herein.

In an embodiment of the present disclosure, the apparatus body 100 is provided with a spin-coater mounting cavity for mounting the spin coater body, such that sinking mounting of the spin coater body 701 is realized, and an overall height of the apparatus is effectively reduced to achieve a more compact structure.

The opening-and-closing cover mechanism for spin coater body 702 is mounted at a top of the spin coater mounting cavity for controlling opening and closing of the spin coater mounting cavity, which can prevent the photoresist from splashing in the spin coating process and reduce difficulty of subsequent cleaning and maintenance.

The opening-and-closing cover mechanism for spin coater body 702 can include a cover plate and a push-pull driver that pushes the cover plate to move, and reference can be made to the design of electric sliding doors, which will not be described in detail.

As shown in FIGS. 6 to 8, the baking device 600 includes a baking machine body 601 and an opening-and-closing cover mechanism for baking machine body 602. The baking machine body 601 can be an existing hot plate, which will not be described in detail.

The apparatus body 100 is provided with a mounting cavity for mounting the baking machine body 601. Similarly, sinking mounting of the baking machine body 601 is realized, and an overall height of the apparatus is effectively reduced to achieve a more compact structure. The opening-and-closing cover mechanism for baking machine body 602 is mounted at a top of the mounting cavity for mounting the baking machine body for controlling opening and closing of the mounting cavity for mounting the baking machine body, which can reduce heat loss in the baking process and improve baking efficiency.

After the piece of wafer 207 is picked up onto the hot plate of the baking machine body 601, the hot plate is started according to a set baking temperature and duration, and after the baking duration is reached, the piece of wafer can be quickly taken away.

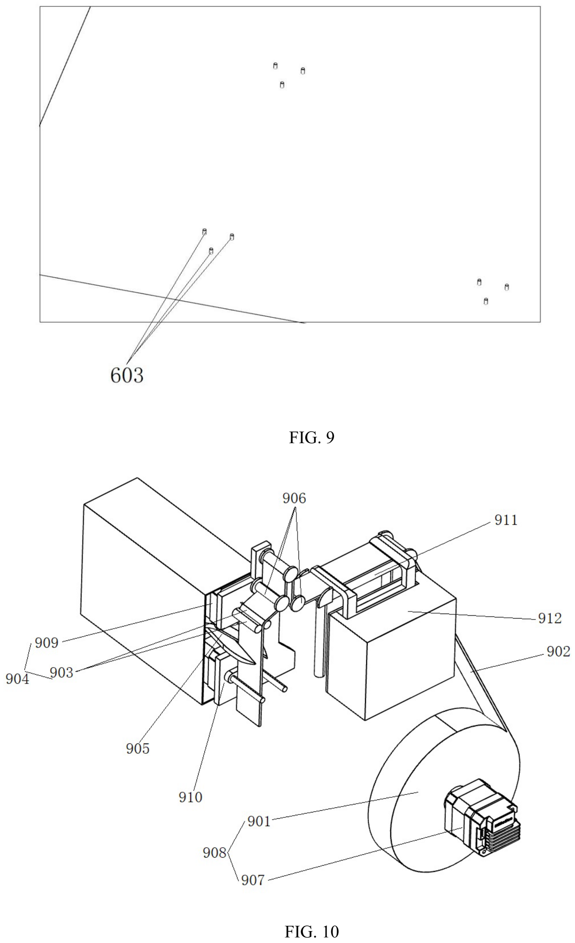

As shown in FIG. 9, to facilitate placement and taking of the piece of wafer 207 on the hot plate, several pins 603 capable of ejecting the respective piece of wafer 207 are provided on the hot plate at a position for placing the piece of wafer 207, and the pins 603 are driven by corresponding ejecting driving mechanisms to realize control of ejecting.

In an embodiment, both the pipetting device 501 and the dispensing device 804 adopt an existing high-precision pipette. In an implementation, a pipette with a function of automatically changing a tip is adopted. In this way, when different photoresists are dripped, the tip can be changed correspondingly to avoid mixing of different photoresists. In an example, the apparatus body 100 is provided with two tip boxes 109 for replacing tips corresponding to the pipetting device 501 and the dispensing device 804 respectively.

As shown in FIG. 2 and FIG. 10, the full-automatic spin coating and baking apparatus for scientific research according to an embodiment of the present disclosure is further provided with a cleaning device 900.

The cleaning device 900 is configured to provide dust-free paper 902.

The manipulator device 400 is further configured to be capable of grasping the dust-free paper 902 and performing a preset cleaning and wiping action. In an embodiment, the manipulator device 400 is configured to grasp the dust-free paper 902 and simulate a human hand to wipe a lining of the spin coating device 700, or wipe a surface of a heating part of the baking device 600.

As shown in FIG. 10, the cleaning device 900 includes a discharging mechanism 908, a pulling mechanism 904 and a cutting mechanism 905.

The discharging mechanism 908 includes a drum 901 and a drum driving motor 907 electrically connected to the drum 901.

The dust-free paper 902 is wound on the drum 901, and the pulling mechanism 904 is configured to pull and release the dust-free paper 902 on the drum 901.

The cutting mechanism 905 is arranged at a side of a discharging end of the pulling mechanism 904 for cutting the released dust-free paper 902. The cutting mechanism 905 is provided with an electrically powered scissors structure. The cutting mechanism 905 can be driven to cut each time a set length of the dust-free paper 902 is pulled out, and then the manipulator device 400 grasps the cut dust-free paper 902 for use.

As shown in FIG. 10, the pulling mechanism 904 includes a roller driving motor 909 and two discharging rollers 903.

The two discharging rollers 903 are rotatably arranged up and down, and a conveying gap for pulling and conveying the dust-free paper 902 is formed between the two discharging rollers. The roller driving motor 909 is electrically connected to at least one of the two discharging rollers 903 for driving the connected discharging roller 903 to rotate so as to pull and release the dust-free paper 902.

As shown in FIG. 10, the cleaning device 900 further includes an alcohol sprayer (not shown).

The alcohol sprayer is configured to spray alcohol on the dust-free paper 902 which is conveyed past the alcohol sprayer, and spraying alcohol on the dust-free paper 902 can improve cleaning effect of the dust-free paper 902. The alcohol sprayer can include a pump, an alcohol bottle and a nozzle, and the pump is electrically connected to the alcohol bottle and the nozzle through a connecting pipe to realize alcohol spraying.

In addition, since an arm of a jaw of the manipulator body 402 can be contaminated with the photoresist during use, a sidewall of the jaw of the manipulator body 402 can be lightly attached to a part of the dust-free paper 902 sprayed with alcohol, and the contaminated photoresist can be wiped off using the moving dust-free paper 902, so as to realize a cleaning of the jaw on the manipulator body 402.

The manipulator device 400 can also grasp the spin-coated piece of wafer 207, and make a back surface of the piece of wafer 207 be lightly attached to the part of the dust-free paper 902 sprayed with alcohol to wipe off photoresist residue on the back surface of the piece of wafer 207 using the moving dust-free paper 902.

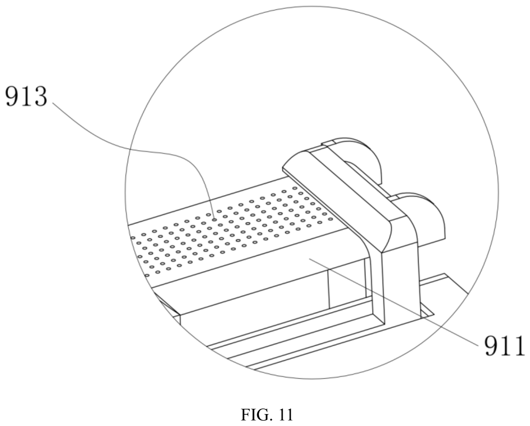

As shown in FIGS. 10 and 11, the full-automatic spin coating and baking apparatus for scientific research further includes a guide roller set 906.

The alcohol sprayer can also be configured to include a spray pump (not shown) and a support platform 911.

The support platform 911 is configured to support the dust-free paper 902 conveyed to pass the support platform. A spraying cavity is provided within the support platform 911, and a spraying hole 913 fluidly communicated with the spraying cavity is formed at a top surface of the support platform 911. The spray pump is communicated with the spray cavity, and the spray pump pumps an alcohol solution in the alcohol bottle into the spray cavity, and then sprays the alcohol solution through the spray hole, that is, the support platform 911 serves as the nozzle, which not only functions in spraying, but also functions in supporting the dust-free paper 902.

The guide roller set 906 is mounted between the support platform 911 and the cutting mechanism 905, such that the dust-free paper 902 conveyed to pass the support platform 911 is attached to the support platform 911.

The manipulator device 400 is further configured to grasp the spin-coated piece of wafer 207 and bring a back surface of the piece of wafer 207 into contact with the dust-free paper 902 on the support platform. The support platform 911 can play a certain supporting role, such that the piece of wafer 207 can be better attached to the dust-free paper 902 for friction to clean the back surface. With the design of the support platform 911, the piece of wafer 207 can be grasped to slide back and forth on the dust-free paper 902 on the support platform 911 to complete cleaning.

In an embodiment, to prevent the dust-free paper 902 from displacing since the piece of wafer 207 rubs against the dust-free paper 902, a paper pressing mechanism 912 can be provided.

The paper pressing mechanism 912 is arranged at a side of the support platform 911 for tightly pressing the dust-free paper 902 on the support platform 911 against the support platform 911. The paper pressing mechanism 912 can include a telescopic cylinder and a pressing rod, and the pressing rod is driven to move by the telescopic cylinder for tightly pressing.

As shown in FIG. 10, a paper winding mechanism 910 is included.

The paper winding mechanism 910 is arranged at a side of the cutting mechanism 905 away from the pulling mechanism 904 for winding the released dust-free paper 902. The paper winding mechanism 910 can include a driving motor for winding paper and a winding fork, and the driving motor for winding paper drives the winding fork to rotate to complete winding of the dust-free paper 902.

When single-layer dust-free paper 902 is used for wiping and cleaning operations, its cleaning effect can not be desirable. Therefore, to improve the cleaning effect, the released dust-free paper 902 is wound by the paper winding mechanism 910 to a required number of layers/thickness and then is cut, and afterwards the manipulator device 400 grasps the wound dust-free paper 902 for the cleaning operation.

As shown in FIG. 1, the apparatus body 100 includes a machine station 101 and a protective cover 102. The protective cover 102 is covered on a top of the machine station 101 to form a closed operation space with the machine station 101.

The first loading device 200 and the second loading device 300 are mounted at the top of the machine station 101 and are located within the protective cover 102. A spin coater mounting cavity for mounting the spin coating device 700 is provided at the top of the machine station 101 within the protective cover 102. A mounting cavity for mounting the baking device 600 is provided at the top of the machine station 101 within the protective cover 102. The manipulator device 400 is mounted at the top of the machine station 101 within the protective cover 102. The control device is mounted within the machine station 101.

The protective cover 102 can be provided with a corresponding operation door, an operation panel 103 mounted in communication connection with the control device, and a buzzer alarm light 104 that can give an alarm.

The machine station 101 is further provided with a first waste recycling port 106 and a second waste recycling port 105. The first waste recycling port 106 can be configured to recycle waste tips and the second waste recycling port 105 can be configured to recycle waste dust-free paper 902.

The machine table 101 is further provided with a placing table (not shown) for placing the cap 304 and the cap 807.

In embodiments of the present disclosure, all device structures provided with electric control can be electrically connected to and controlled by the control device to realize automation.

With the cleaning device 900 designed above, the following three cleaning operations can be realized.
S1. Cleaning of the back surface of the piece of wafer 207 can be realized.
S2. Cleaning of the jaw on the manipulator body 402 can be realized.
S3. It can be realized that the manipulator body 402 grasps the dust-free paper 902 to wipe and clean some parts on the apparatus.

The full-automatic spin coating and baking apparatus for scientific research provided in the present disclosure has following advantages.
1. The manipulator device 400 supporting pieces of wafer 207 with sizes of 1 cm × 1 cm and 2 cm × 2 cm can identify a position where a piece of wafer is placed and a size of the piece of wafer 207 in combination with the vision device 502, to realize accurate grasping of the piece of wafer 207, avoid damage to the piece of wafer 207, reduce a scrap rate, and save cost.
2. The position of the adsorption hole in the spin coating device 700 can be identified through the vision device 502, and is then compared with a current position of the manipulator body 402 to calculate fine adjustment data of the position of the manipulator body 402 for fine adjustment control, so as to ensure that each piece of wafer 207 can be accurately placed at the center of the adsorption hole, thus ensuring process stability.
3. After the piece of wafer is placed on the spin coating device 700, the pipetting device 501 with high precision is adopted to replace a traditional dropper for photoresist dripping. In contrast, the pipetting device 501 can accurately control dripped amount of photoresist on each piece of wafer 207, which greatly avoids waste of photoresist and contamination of other device modules around by excessive photoresist during spinning. Meanwhile, direct contact of researchers with the photoresist is prevented, and personnel health is guaranteed. In addition, when a batch of piece of wafer 207 is coated, an overall photoresist demand can be estimated by considering the number of pieces of wafer 207 and a photoresist demand of a single piece of wafer 207, and a sufficient amount of photoresist can be aspirated by the pipetting device 501 at one time. After each piece of wafer 207 is placed, the photoresist can be dripped to the right center of the piece of wafer 207 with the aid of image recognition by the vision device 502. In this way, the operation of aspirating photoresist before coating each piece of wafer 207 is avoided, overall process efficiency is effectively improved, accurate dripping position of each piece of wafer is ensured, and process repeatability is improved.
4. By additionally providing the cleaning device 900, the back surface of the coated piece of wafer 207 can be cleaned to prevent excessive photoresist from sticking to the hot plate of the baking device 600 and contaminating the hot plate. The jaw of the manipulator body 402 and the lining of the spin coating device 700 can also be cleaned. Cleaning the lining of the spin coating device 700 can avoid cross-contamination caused by multiple spin coating of different photoresists, and ensure that the interior of the spin coating device 700 is in a clean environment. The cleaning device 900 employs the dust-free paper 902 that is pulled out and transported at a uniform speed, and is provided with the alcohol sprayer to realize convey of the dust-free paper 902 infiltrated with alcohol. Using the manipulator device 400 to grasp the piece of wafer 207 to be cleaned and place it on a surface of a conveyor belt of a dust-free paper 902, residual photoresist at a bottom of the piece of wafer 207 can be taken away. For the self-cleaning of the jaw of the manipulator body 402, similar to cleaning of the piece of wafer 207, the dust-free paper 902 is employed to wipe an inner sidewall of the jaw at a uniform speed to complete the cleaning. For cleaning of the lining of the spin coating device 700, it is necessary to use the cutting mechanism 905 to cut off a piece of dust-free paper 902, which is then clamped by the manipulator device 400 to simulate a human hand to wipe the surface of the lining.

Generally speaking, the apparatus provided in the present disclosure can realize a full-automatic spin coating and baking process of a piece of wafer 207, and can make dynamic adjustment according to different coating parameters such as rotation speed, acceleration and duration, and baking parameters such as baking temperature and duration set by users according to different technological process, thus improving the process repeatability and stability, improving the scientific research efficiency, avoiding waste of photoresist and ensuring safety of scientific researchers.

The working flow of the apparatus is as follows.
S1. The scientific researcher loads the piece of wafer 207 to the first loading device 200, closes the operation door of the apparatus body 100 and starts the apparatus.
S2. The control device controls the manipulator device 400 to operate, during which the vision device 502 acquires image information of the first loading device 200, and identifies a position where the piece of wafer 207 is placed and a size of the piece of wafer 207. After the position and size of the piece of wafer 207 are determined, the manipulator device 400 is controlled to operate to grasp the piece of wafer 207 by the manipulator body 402. Before grasping, the piece of wafer 207 is ejected up by the ejecting column by a certain height. If pretreatment is required, before execution of operation S2, the manipulator device 400 is controlled to grasp the forking tool 108 and transport the box cover 202 with the piece of wafer 207 held on the first loading device 200 to the pretreatment device 107 for pretreatment.
S3. The manipulator body 402 is controlled to move above the vacuum absorption hole of the spin coating device 700, during which the vision device 502 identifies the position of the vacuum absorption hole, and after the position of the vacuum absorption hole is determined, the manipulator body 402 is controlled to place the piece of wafer 207 at the center of the vacuum absorption hole.
S4. The pipetting device 501 is controlled to move to the tip box 109 to be equipped with a 1 ml tip, and then move above the container bottle 303 in the bottle fixing mechanism 305, during or before which, the bottle opening device 801 is controlled to open the cap 304 of the container bottle 303. After the pipetting device 501 moves in place, the photoresist in the container bottle 303 is aspirated (of course, it is also possible to transport the container bottle 303 to the bottle fixing mechanism 305 by controlling the bottle opening device 801 before operation S1, and open the cap 304 to wait for aspiration by the pipetting device 501). The aspirated amount of photoresist is determined by the number and size of the piece of wafer 207 to be coated that are acquired by the image recognition and the amount of photoresist for a single piece of wafer set by the user in the system. After the photoresist is aspirated, the pipetting device 501 moves to be above the piece of wafer 207 in the spin coating device 700, and the position of the pipetting device 501 is finely adjusted according to the vision device 502 to ensure that the tip of the pipetting device 501 is at the center of the piece of wafer 207. After adjustment, the tip moves down to a dripping position to drip the photoresist. After the dripping is completed, the pipetting device 501 moves up, and the opening-and-closing cover mechanism for spin coater body 702 of the spin coating device 700 is automatically closed.
S5. The spin coating device 700 is controlled to operate to finish the spin coating of the piece of wafer 207 according to a preset rotation speed and duration.
S6. After the spin coating is completed, the opening-and-closing cover mechanism for spin coater body 702 is opened, the manipulator body 402 is controlled to grasp the piece of wafer 207 and transfer the piece of wafer to the cleaning device 900 to clean the back surface of the piece of wafer 207, and then the piece of wafer is transferred to the baking device 600. After transferring, the opening-and-closing cover mechanism for baking machine body 602 is closed, and the baking device 600 is controlled to operate according to baking parameters set, such as baking temperature and duration, to realize baking.
S7. During baking, the manipulator body 402 is controlled to move to the cleaning device 900 to clean an inner wall of the jaw, and after cleaning, move above the baking device 600 to wait for completion of baking. After baking is completed, the opening-and-closing cover mechanism for baking machine body 602 is opened, and the manipulator body 402 is controlled to grasp the piece of wafer 207 and transfer the piece of wafer 207 back to the first loading device 200.
S8. Operations S1 to S7 are repeated until spin coating and baking operations are completed for all of the pieces of wafer 207 to be processed in the first loading device 200. Finally, the manipulator body 402 is controlled to grasp a cut piece of dust-free paper 902 to simulate a manual action to wipe and clean the lining of the spin coating device 700.

During use, the researcher only needs to place the container bottle 303 and the piece of wafer 207 at corresponding positions and set key process parameters such as usage amount of photoresist, the speed and duration of spin coating, the baking temperature/duration of each piece of wafer 207 at the operation panel 103, to automatically complete the spin coating and baking operations of the piece of wafer 207, which ensures the process repeatability and stability, improves the scientific research efficiency, ensures the safety of personnel, and reduces waste and consumption of expensive photoresist.

The full-automatic spin coating and baking apparatus for scientific research provided in the present disclosure has been described in detail above. According to idea of the embodiments of the present disclosure, changes in specific implementations and application scope can be made by those having ordinary skills in the art. To sum up, contents of this specification should not be understood as a limitation to the present disclosure.

## Claims

1. A full-automatic spin coating and baking apparatus for scientific research, comprising an apparatus body (100), a first loading device (200), a second loading device (300), a manipulator device (400), a spin coating device (700), a baking device (600), a pipetting device (501), a vision device (502) and a control device, wherein:
the first loading device (200) is mounted on the apparatus body (100) for loading several pieces of wafer (207);
the second loading device (300) is mounted on the apparatus body (100) for loading photoresist;
the spin coating device (700) is mounted on the apparatus body (100) for spin coating the several pieces of wafer (207) dripped with the photoresist;
the baking device (600) is mounted on the apparatus body (100) for baking the piece of wafer (207) subjected to spin coating;
the manipulator device (400) is mounted on the apparatus body (100) and comprises a manipulator body (402) and a manipulator displacement driving mechanism (401);
the manipulator body (402) is capable of grasping the several pieces of wafer (207);
the manipulator device (400) is configured to transport the several pieces of wafer (207) among the first loading device (200), the spin coating device (700) and the baking device (600);
the pipetting device (501) is electrically connected to the manipulator displacement driving mechanism (401), and is capable of aspirating the photoresist from the second loading device (300) and dripping the photoresist on the several pieces of wafer (207) under driving of the manipulator device (400);
the vision device (502) is electrically connected to the manipulator displacement driving mechanism (401) for identifying a position of a target object and transmitting the position to the control device; and
the control device is electrically connected to the manipulator device (400), the spin coating device (700), the baking device (600), the pipetting device (501) and the vision device (502).

2. The full-automatic spin coating and baking apparatus for scientific research of claim 1, wherein the first loading device (200) comprises a first loading body structure (203);
each of several first loading grooves (205) for holding a respective piece of wafer of several pieces of wafer (207) of a first preset specification is defined at a top of the first loading body structure (203);
each of the several first loading grooves (205) is provided with a respective second loading groove of several second loading grooves (206) at a center thereof, each of which is configured for holding a respective one of several pieces of wafer (207) of a second preset specification;
each of the several second loading grooves (206) is movably provided with a respective one of several ejector columns (204) in a penetrating way at a central position thereof; and
the several ejector columns (204) are each electrically connected to a respective ejector driver or are electrically connected to the same ejector driver, so as to eject the respective piece of wafer (207) located on the respective first loading groove (205) or the respective second loading groove (206) by a preset height.

3. The full-automatic spin coating and baking apparatus for scientific research of claim 2, wherein the first loading body structure (203) comprises a box body (201) and a box cover (202) detachably covered on the box body (201);
each of the several first loading grooves (205) and each of the several second loading grooves (206) are arranged at a top of the box cover (202);
the full-automatic spin coating and baking apparatus for scientific research further comprises a pretreatment device (107) and a forking tool (108), wherein:
the pretreatment device (107) is mounted on the apparatus body (100);
the forking tool (108) is placed on the apparatus body (100);
the manipulator body (402) is further capable of grasping the forking tool (108);
the box cover (202) is provided with a socket for inserting the forking tool (108);
the manipulator device (400) is further configured to grasp the forking tool (108) and transport the box cover (202) between the first loading device (200) and the pretreatment device (107) through the forking tool (108); and
the pretreatment device (107) is configured to pretreat each of the several pieces of wafer (207) on the transported box cover (202).

4. The full-automatic spin coating and baking apparatus for scientific research of claim 3, wherein the first loading device (200) is provided in two.

5. The full-automatic spin coating and baking apparatus for scientific research of claim 1, wherein the second loading device (300) comprises a second loading body structure (301); and
the second loading body structure (301) is provided with several container fixing grooves (302) each for fixing a respective one of several container bottles (303) storing the photoresist.

6. The full-automatic spin coating and baking apparatus for scientific research of claim 5, wherein each of the several container bottles (303) is provided with a respective one of several caps (304) which is allowed to be screwed on and screwed off; and
The manipulator body (402) is further configured to be capable of screwing any one of the several caps (304) to open or close a respective one of the several container bottles (303).

7. The full-automatic spin coating and baking apparatus for scientific research of claim 6, wherein the second loading device (300) further comprises a bottle fixing mechanism (305);
the manipulator device (400) is further configured to transport a certain container bottle(303) of the several container bottles between the second loading body structure (301) and the bottle fixing mechanism (305);
the bottle fixing mechanism (305) is configured to clamp and fix the transported container bottle (303); and
the pipetting device (501) is capable of aspirating the photoresist from the container bottle (303) clamped and fixed on the bottle fixing mechanism (305).

8. The full-automatic spin coating and baking apparatus for scientific research of claim 5, wherein each of the several container bottles (303) is provided with the respective one of the several caps (304) which is allowed to be unscrewed;
the full-automatic spin coating and baking apparatus for scientific research further comprises a bottle opening device (801); and
the bottle opening device (801) is mounted on the apparatus body (100) and is capable of turning any one of the several caps (304) to open or close its respective container bottle (303).

9. The full-automatic spin coating and baking apparatus for scientific research of claim 8, wherein the second loading device (300) further comprises a bottle fixing mechanism (305);
the bottle opening device (801) comprises a bottle opening displacement driving mechanism (802) and a bottle opening mechanism (803), wherein:
the bottle opening mechanism (803) is capable of grasping any one of the several container bottles (303);
the bottle opening displacement driving mechanism (802) is electrically connected to the bottle opening mechanism (803) for driving the bottle opening mechanism (803) to transport any one of the several container bottles (303) between the second loading body structure (301) and the bottle fixing mechanism (305);
the bottle fixing mechanism (305) is configured to clamp and fix the transported container bottle (303);
the bottle opening mechanism (803) is also capable of screwing its respective cap (304) to open or close the transported container bottle (303); and
the pipetting device (501) is capable of aspirating the photoresist from the container bottle (303) clamped and fixed on the bottle fixing mechanism (305).

10. The full-automatic spin coating and baking apparatus for scientific research of claim 9, further comprising a dispensing device (804), a stock solution tank (806) and a dispensing holder (805), wherein:
the stock solution tank (806) is mounted on the apparatus body (100) and is provided with a cap (807) which is allowed to be screwed;
the bottle opening mechanism (803) is also capable of screwing the cap (807) to open or close the stock solution tank (806);
the dispensing device (804) is electrically connected to the bottle opening displacement driving mechanism (802) and is capable of aspirating the photoresist from the stock solution tank (806) and dripping the photoresist into a container bottle (303)of the several container bottles in the bottle fixing mechanism (305) under driving of the bottle opening displacement driving mechanism (802); and
the dispensing holder (805) is mounted on the apparatus body (100) for loading the container bottle (303) subjected to dispensing.

11. The full-automatic spin coating and baking apparatus for scientific research of claim 1, wherein the spin coating device (700) comprises a spin coater body (701) and an opening-and-closing cover mechanism for spin coater body (702);
the apparatus body (100) is provided with a mounting cavity for mounting the spin coater body (701); and
the opening-and-closing cover mechanism for spin coater body (702) is mounted at a top of the mounting cavity for mounting the spin coater body for controlling opening and closing of the spin coater mounting cavity.

12. The full-automatic spin coating and baking apparatus for scientific research of claim 1, wherein the baking device (600) comprises a baking machine body (601) and an opening-and-closing cover mechanism for baking machine body (602), wherein:
the apparatus body (100) is provided with a mounting cavity for mounting the baking machine body (601); and
the opening-and-closing cover mechanism for baking machine body (602) is mounted at a top of the mounting cavity for mounting the baking machine body for controlling opening and closing of the mounting cavity for mounting the baking machine body.

13. The full-automatic spin coating and baking apparatus for scientific research of claim 1, wherein the pipetting device (501) is a pipette.

14. The full-automatic spin coating and baking apparatus for scientific research of claim 1, further comprising a cleaning device (900), wherein:
the cleaning device (900) is configured to provide dust-free paper; and
the manipulator device (400) is further configured to be able to grasp the dust-free paper and perform a preset cleaning and wiping action.

15. The full-automatic spin coating and baking apparatus for scientific research of claim 14, wherein the cleaning device (900) comprises a discharging mechanism (908), a pulling mechanism (904) and a cutting mechanism, wherein:
the discharging mechanism (908) comprises a drum (901) and a drum driving motor (907) electrically connected to the drum (901);
the drum (901) is configured to wind the dust-free paper (902);
the pulling mechanism (904) is configured to pull out and release the dust-free paper (902) on the drum (901); and
the cutting mechanism (905) is arranged at a side of a discharging end of the pulling mechanism (904) for cutting the released dust-free paper (902).

16. The full-automatic spin coating and baking apparatus for scientific research of claim 15, the pulling mechanism (904) comprises a roller driving motor (909) and two discharging rollers (903);
the two discharging rollers (903) are rotatably arranged up and down, and a conveying gap for pulling and conveying the dust-free paper (902) is formed between the two discharging rollers (903); and
the roller driving motor (909) is electrically connected to at least one of the two discharging rollers (903) for driving the corresponding discharging roller (903) to rotate.

17. The full-automatic spin coating and baking apparatus for scientific research of claim 15, wherein the cleaning device (900) further comprises an alcohol sprayer; and
the alcohol sprayer is configured to spray alcohol on the dust-free paper (902) which is conveyed to pass the alcohol sprayer.

18. The full-automatic spin coating and baking apparatus for scientific research of claim 17, further comprising a guide roller set (906), wherein:
the alcohol sprayer comprises a spraying pump and a support platform (911);
the support platform (911) is configured to support the dust-free paper (902) conveyed to pass the support platform (911);
a spraying cavity is provided within the support platform (911), and a spraying hole fluidly communicated with the spraying cavity is formed at a top surface of the support platform (911);
the spraying pump is communicated with the spraying cavity;
the guide roller set (906) is mounted between the support platform (911) and the cutting mechanism (905), such that the dust-free paper (902) conveyed to pass the support platform (911) is attached to the support platform (911); and
the manipulator device (400) is further configured to grasp a spin-coated piece of wafer of the several pieces of wafer (207) and bring a back surface of the spin-coated piece of wafer (207) in contact with the dust-free paper (902) on the support platform (911).

19. The full-automatic spin coating and baking apparatus for scientific research of claim 18, further comprising a paper pressing mechanism (912), wherein:
the paper pressing mechanism (912) is arranged at a side of the support platform (911) for tightly pressing the dust-free paper (902) on the support platform (911) against the support platform (911).

20. The full-automatic spin coating and baking apparatus for scientific research of claim 15, further comprising a paper winding mechanism (910), wherein:
the paper winding mechanism (910) is arranged at a side of the cutting mechanism (905) away from the pulling mechanism for winding the released dust-free paper (902).

21. The full-automatic spin coating and baking apparatus for scientific research of claim 1, wherein the apparatus body (100) comprises a machine station (101) and a protective cover (102), wherein:
the protective cover (102) is covered on a top of the machine station (101);
the first loading device (200) and the second loading device (300) are mounted at a top of the machine station (101) and are located within the protective cover (102);
a mounting cavity for mounting the spin coating device (700) is provided at the top of the machine station (101) within the protective cover (102);
a mounting cavity for mounting the baking device is provided at the top of the machine station (101) within the protective cover (102);
the manipulator device (400) is mounted at the top of the machine station (101) within the protective cover (102); and
the control device is mounted within the machine station (101).
